# EUROPEAN PATENT APPLICATION

(11) **EP 3 322 264 A1**
(43) Date of publication of application: **16.05.2018**
(21) Application number: 16821085.4
(22) Date of filing: 27.04.2016
(51) Int. Cl.: H05K 1/14, H05K 1/18, H05K 3/28, H05K 3/36

(54) **HIGH FREQUENCY MODULE**

(30) Priority: 08.07.2015 JP 2015137056
(71) Applicant: Alps Electric Co., Ltd., Tokyo 145-8501 (JP)
(72) Inventor: NAKAGAWA, Masashi, Tokyo 145-8501 (JP); SEIKE, Takehiro, Tokyo 145-8501 (JP); WATANABE, Hideki, Tokyo 145-8501 (JP); SHIBUYA, Yoshihisa, Tokyo 145-8501 (JP); KUWANA, Shunji, Tokyo 145-8501 (JP)
(74) Representative: Schmitt-Nilson Schraud Waibel Wohlfrom Patentanwälte Partnerschaft mbB
(86) International application number: PCT/JP2016/063208
(87) International publication number: WO 2017/006614

(57) **Abstract**

[Object]

To provide a high-frequency module that has a simple structure and that contributes to size reduction of a device.

[Solution]

A high-frequency module 100 includes a wiring substrate 10 and an antenna substrate 20 disposed on an upper surface of the wiring substrate 10, an antenna 21 is formed by a metal pattern 21a on the antenna substrate 20, a non-conductive adhesive 11 and a conductive adhesive 13 are present between the wiring substrate 10 and the antenna substrate 20, and a spacer 23 is provided between the non-conductive adhesive 11 and the conductive adhesive 13. Thus, by the spacer 23, it is possible to prevent contact between the non-conductive adhesive 11 and the conductive adhesive 13 and it is also possible to ensure a required height between the wiring substrate 10 and the antenna substrate 20. In addition, it is possible to achieve connection between the wiring substrate 10 and the antenna substrate 20 by a simple structure.

## Description

### Technical Field

The present invention relates to a high-frequency module and particularly relates to a high-frequency module that is used such that two substrates are overlapped with each other.

### Background Art

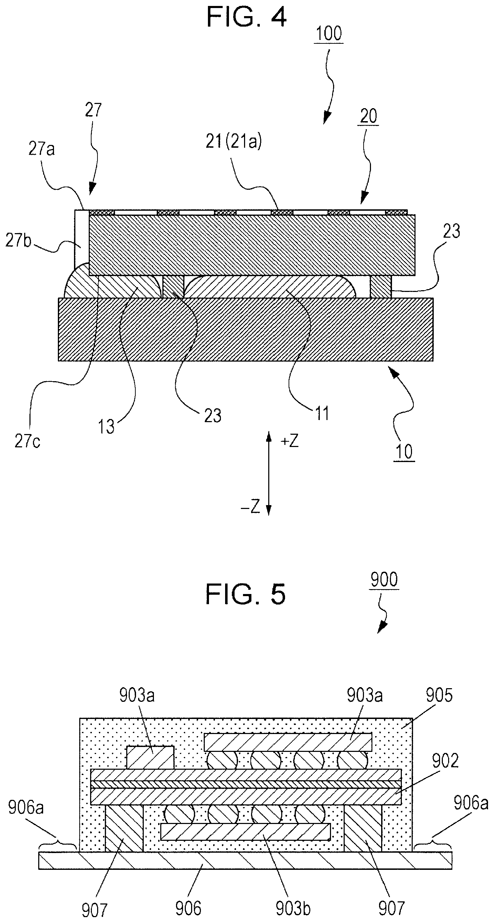

In recent years, a high-frequency module that is formed such that two substrates are overlapped with each other has been developed for size reduction. In the high-frequency module in which the two substrates are combined, it is necessary to structurally connect the two substrates, and it is also necessary to electrically connect the two substrates. Patent Literature 1 discloses a high-frequency module that includes two substrates and that has a structure in which the two substrates are structurally and electrically connected to each other. Hereinafter, a resin-sealed substrate device 900 that is such a high-frequency module will be described with reference to Fig. 5.

The resin-sealed substrate device 900 includes a resin portion 905 that covers an electronic component 903b mounted on the lower surface of a substrate 902 and that is provided at both sides of the substrate 902. The resin-sealed substrate device 900 is provided with: an auxiliary plate 906 provided on the lower surface of the resin portion 905; and a plurality of spacers 907 one of which is fixed to the auxiliary plate 906 and the other of which is fixed to the substrate 902 and embedded within the resin portion 905. The spacers 907 are formed of a conductive metal, and the heights thereof are set so as to be higher than the height of the electronic component 903b, which is mounted on the lower surface of the substrate 902.

Since the auxiliary plate 906 and the substrate 902 are structurally connected to each other by the plurality of spacers 907 as described above, when the auxiliary plate 906 is mounted on a mold, it is possible to stably maintain the position of the substrate 902 even in a resin portion forming step. In addition, the effect that it is possible to electrically connect the auxiliary plate 906 and the substrate 902 by the spacers 907, is achieved.

### Citation List

### Patent Literature

PTL 1: Japanese Unexamined Patent Application Publication No. 2012-028486

### Summary of Invention

### Technical Problem

However, in the resin-sealed substrate device 900, it is necessary to mount the plurality of spacers 907 made of a metal on the auxiliary plate 906 in order to electrically connect the auxiliary plate 906 and the substrate 902, so that the number of components increases and the structure becomes complicated. Therefore, there is a problem that size reduction of a device is hindered.

The present invention has been made in view of such circumstances of the related art, and provides a high-frequency module that has a simple structure and that contributes to size reduction of a device.

### Solution to Problem

In order to solve the above problem, a high-frequency module according to the present invention includes a wiring substrate and an antenna substrate disposed on an upper surface of the wiring substrate, an antenna is formed by a metal pattern on the antenna substrate, a non-conductive adhesive and a conductive adhesive are present between the wiring substrate and the antenna substrate, and a spacer is provided between the non-conductive adhesive and the conductive adhesive.

In the high-frequency module configured as described above, by the spacer, it is possible to prevent contact between the non-conductive adhesive and the conductive adhesive and it is also possible to ensure a required height between the wiring substrate and the antenna substrate. In addition, since it is possible to achieve electric connection between the wiring substrate and the antenna substrate by a simple structure, it is possible to contribute to size reduction of a device.

In the above configuration, the spacer surrounds the non-conductive adhesive, a gap is formed in a portion of the spacer and is not formed around the conductive adhesive.

In the high-frequency module configured as described above, the conductive adhesive is prevented from being mixed with the non-conductive adhesive, and degassing is possible in bonding the antenna substrate and the wiring substrate to each other. As a result, it is possible to more assuredly bond the antenna substrate and the wiring substrate to each other.

In the above configuration, the spacer is provided by a solder resist being formed on a surface of the antenna substrate at the wiring substrate side by a print method, and the high-frequency module is produced by the non-conductive adhesive and the conductive adhesive being applied to a surface of the wiring substrate at the antenna substrate side and then the antenna substrate and the wiring substrate being bonded to each other.

In the high-frequency module configured as described above, since the spacer is formed on the surface of the antenna substrate at the wiring substrate side at which no wiring pattern is present, it is possible to increase the accuracy of the height of the spacer. In addition, the respective amounts of the non-conductive adhesive and the conductive adhesive applied in bonding the wiring substrate and the antenna substrate to each other are limited by the spacer, and thus it is possible to minimize the respective amounts of the non-conductive adhesive and the conductive adhesive to be used.

### Advantageous Effects of Invention

In the high-frequency module according to the present invention, by the spacer, it is possible to prevent contact between the non-conductive adhesive and the conductive adhesive and it is also possible to ensure a required height between the wiring substrate and the antenna substrate. In addition, since it is possible to achieve connection between the wiring substrate and the antenna substrate by a simple structure, it is possible to contribute to size reduction of a device.

### Brief Description of Drawings

[Fig. 1] Fig. 1 is a perspective view showing the appearance of a high-frequency module.
[Fig. 2] Fig. 2 is a schematic view of the high-frequency module as seen from above.
[Fig. 3] Fig. 3 is a cross-sectional view of each of a wiring substrate and an antenna substrate before bonding.
[Fig. 4] Fig. 4 is a cross-sectional view of the high-frequency module.
[Fig. 5] Fig. 5 is a cross-sectional view of a resin-sealed substrate device related to a related art example.

### Description of Embodiments

Hereinafter, a high-frequency module according to the present invention will be described with reference to the drawings. The high-frequency module according to the present invention is, for example, a small-sized high-frequency module that is used for a wireless LAN (Local Area Network), Bluetooth (registered trademark), or the like and that has an antenna. The use of the high-frequency module according to the present invention is not limited to an embodiment described below, and is changeable as appropriate. In the present specification, unless otherwise specified, a description will be given with the +X side in each drawing defined as the right side, the -X side in each drawing defined as the left side, the +Y side in each drawing defined as the depth side, the -Y side in each drawing defined as the near side, the +Z side in each drawing defined as the upper side, and the -Z side in each drawing defined as the lower side.

### [Embodiment]

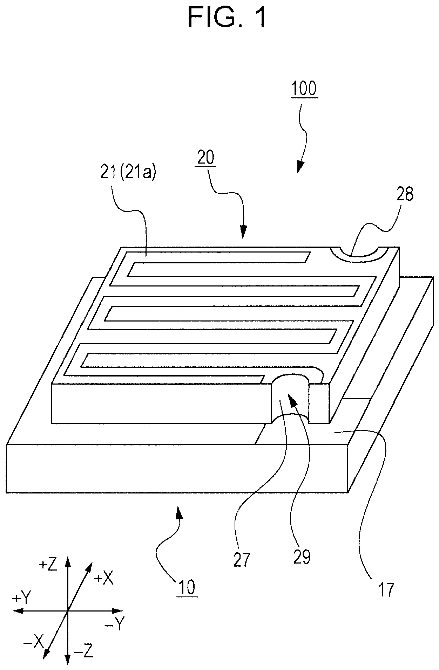

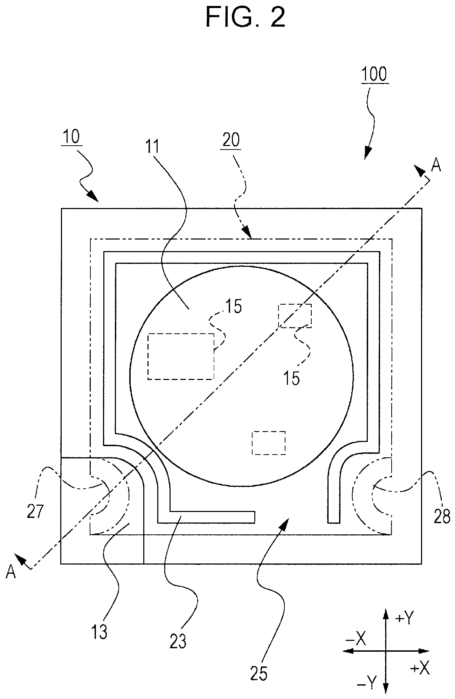

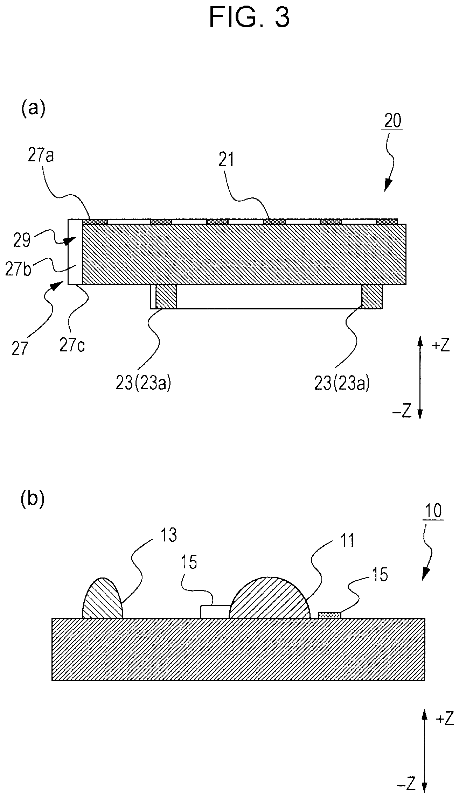

First, the structure of a high-frequency module 100 according to an embodiment of the present invention will be described with reference to Figs. 1 to 4. Fig. 1 is a perspective view showing the appearance of the high-frequency module 100, and Fig. 2 is a schematic view of the high-frequency module 100 as seen from above. In addition, Fig. 3 is a cross-sectional view of each of a wiring substrate 10 and an antenna substrate 20, before bonding, as seen from the line A-A shown in Fig. 2. Fig. 3(a) shows the antenna substrate 20 before bonding, and Fig. 3(b) shows the wiring substrate 10 before bonding. Moreover, Fig. 4 is a cross-sectional view of the high-frequency module 100 as seen from the line A-A shown in Fig. 2. In Fig. 2, for easy understanding of the internal structure, on the assumption that the wiring substrate 10 is transparent, the wiring substrate 10 is shown by a chain double dashed line, and an antenna 21 is not shown.

As shown in Fig. 1, the high-frequency module 100 is configured to include the wiring substrate 10 having a rectangular shape and the antenna substrate 20 that is disposed on the upper surface of the wiring substrate 10 and that has a rectangular shape with a smaller area than the wiring substrate 10. The antenna 21 is formed on the antenna substrate 20 by a metal pattern 21a having conductivity. In addition, a high-frequency circuit (not shown) is formed on the wiring substrate 10, and the antenna 21 and the high-frequency circuit are connected to each other. The high-frequency module 100, which includes the antenna substrate 20 and the wiring substrate 10, is produced by cutting an aggregate substrate (not shown) formed by a plurality of antenna substrates and a plurality of wiring substrates.

In the present embodiment, as the antenna 21, a monopole antenna that has a meander shape and one end of which is released is adopted, but the antenna 21 may be an another type of antenna such as an inverse F type antenna.

An electrode portion 27 is formed at the other end of the antenna 21. The electrode portion 27 is provided for connecting the antenna 21 and the high-frequency circuit formed on the wiring substrate 10. The electrode portion 27 is formed by an upper surface electrode portion 27a located on the upper surface of an end portion at the -Y side of one side at the -X side of the antenna substrate 20 shown in Fig. 1, a lower surface electrode portion 27c located on the lower surface of the end portion, and a side surface electrode portion 27b located on the side surface of the end portion (see Fig. 3(a)). The electrode portion 27 is formed by cutting a through hole 29 that is provided when the antenna substrate 20 is a portion of the aggregate substrate.

An electrode portion 28 is provided at a side opposing the side at the -X side of the antenna substrate 20 at which the electrode portion 27 is provided. The electrode portion 28 is not connected to any of the high-frequency circuit on the wiring substrate 10 and the antenna 21 on the antenna substrate 20. The electrode portion 28 is a portion of an electrode portion for another antenna substrate on the aggregate substrate that is formed when the antenna substrate 20 is produced by cutting the aggregate substrate, is not used for the high-frequency module 100, and does not influence the high-frequency module 100.

As shown in Fig. 2, electronic components 15 such as an integrated circuit are disposed on the wiring substrate 10, and are connected to each other by a wiring pattern (not shown) to form the above-described high-frequency circuit. A plurality of the electronic components 15 may be sealed together by a resin. To the electronic components 15, which form the high-frequency circuit, the antenna 21 is connected via the above-described electrode portion 27, and a high-frequency signal transmitted or received by the antenna 21 is processed.

As shown in Figs. 2 and 4, a non-conductive adhesive 11 that does not have conductivity and a conductive adhesive 13 that has conductivity are present between the wiring substrate 10 and the antenna substrate 20, and a spacer 23 is provided between the non-conductive adhesive 11 and the conductive adhesive 13.

The non-conductive adhesive 11 covers the plurality of the electronic components 15 as shown in Fig. 2, and also adheres to the upper surface of the wiring substrate 10 and the lower surface of the antenna substrate 20 to structurally connect and fix the wiring substrate 10 and the antenna substrate 20 as shown in Fig. 4.

As shown in Fig. 4, the conductive adhesive 13 adheres to the upper surface of the wiring substrate 10 and the lower surface of the antenna substrate 20 to structurally connect and fix the wiring substrate 10 and the antenna substrate 20 and also electrically connect the high-frequency circuit provided on the wiring substrate 10 and the antenna 21 on the antenna substrate 20 via the electrode portion 27. The conductive adhesive 13 adheres to the lower surface electrode portion 27c, which is provided on the lower surface of the antenna substrate 20, and also adheres to the side surface electrode portion 27b, which is provided on the side surface of the antenna substrate 20, to more assuredly connect the wiring substrate 10 and the antenna substrate 20.

As shown in Fig. 2, the spacer 23 surrounds the non-conductive adhesive 11, and a gap 25 is formed in a portion of the spacer 23 at the near side (-Y side) of the high-frequency module 100. The gap 25 is provided at a position at which the conductive adhesive 13 is not in contact with the spacer 23. That is, in an area where the non-conductive adhesive 11 and the conductive adhesive 13 oppose to each other with the spacer 23 interposed therebetween, the gap 25 is not present, and the spacer 23 is formed. Therefore, since the spacer 23 fully separates the non-conductive adhesive 11 and the conductive adhesive 13, the non-conductive adhesive 11 and the conductive adhesive 13 are not mixed.

Next, a method for producing the high-frequency module 100 will be described with reference to Figs. 1 to 4.

The antenna 21 is formed on the antenna substrate 20 by the metal pattern 21a, which has conductivity, being printed on the surface at the upper side (+Z side) of the antenna substrate 20 as shown in Figs. 1 and 3(a).

The spacer 23 is formed on the wiring substrate 10 by a solder resist 23a shown in Fig. 3(a) being provided on the surface at the lower side of the antenna substrate 20, that is, at the wiring substrate 10 side by a print method, and the solder resist 23a being cured by heat. A wiring pattern is not provided on the surface at the lower side of the antenna substrate 20 before the solder resist 23a is printed, and this surface is a flat surface.

The height of the spacer 23 is set so as to be higher than the height of each electronic component 15 shown in Figs. 2 and 3(b). Thus, the surface at the lower side of the antenna substrate 20 is located higher than the plurality of the electronic components 15 when the antenna substrate 20 is disposed on the upper surface of the wiring substrate 10.

As shown in Fig. 3(b), on the surface at the antenna substrate 20 side (the surface at the +Z side) of the wiring substrate 10, the electronic components 15 are mounted, and each of the non-conductive adhesive 11 and the conductive adhesive 13 is applied to a predetermined position in a predetermined amount. The heights of the non-conductive adhesive 11 and the conductive adhesive 13 applied at this time are higher than the height of the spacer 23 formed on the antenna substrate 20.

In the present embodiment, the spacer 23 is formed on the surface at the lower side of the antenna substrate 20, that is, at the wiring substrate 10 side of the antenna substrate 20. However, the space 23 may be formed on the surface at the upper side of the wiring substrate 10, that is, at the antenna substrate 20 side of the wiring substrate 10. In this case, the spacer 23 is formed in a step before the electronic components 15 are mounted on the wiring substrate 10.

Next, the antenna substrate 20 and the wiring substrate 10 formed as described above are bonded to each other by overlapping the antenna substrate 20 and the wiring substrate 10 with each other and pressing the antenna substrate 20 and the wiring substrate 10 from the upper and lower sides. The high-frequency module 100 is produced by the antenna substrate 20 and the wiring substrate 10 being bonded to each other. When the antenna substrate 20 and the wiring substrate 10 are bonded to each other, the non-conductive adhesive 11 and the conductive adhesive 13 that have been applied on the wiring substrate 10 are pressed and spread between the antenna substrate 20 and the wiring substrate 10 as shown in Fig. 4.

The non-conductive adhesive 11 that has been pressed and spread between the antenna substrate 20 and the wiring substrate 10 is stopped by the spacer 23 as shown in Fig. 4 and does not spread outward of the spacer 23. Meanwhile, the conductive adhesive 13 that has been pressed and spread between the antenna substrate 20 and the wiring substrate 10 is stopped at one side thereof by the spacer 23, and the other side thereof stops at an end portion of the wiring substrate 10. That is, in bonding the wiring substrate 10 and the antenna substrate 20 to each other, the respective amounts of the non-conductive adhesive 11 and the conductive adhesive 13 applied are limited by the spacer 23.

Since the gap 25 is provided in the spacer 23 as described above, it is possible to discharge gas remaining between the antenna substrate 20 and the wiring substrate 10, through the gap 25 in bonding the antenna substrate 20 and the wiring substrate 10 to each other. That is, degassing is possible.

Through such production steps, as shown in Fig. 4, the conductive adhesive 13 reaches the lower surface electrode portion 27c and the side surface electrode portion 27b of the electrode portion 27, which are located on the end portion of the antenna substrate 20, so that the antenna 21 on the antenna substrate 20 and the high-frequency circuit on the wiring substrate 10 are electrically connected to each other, and the antenna substrate 20 and the wiring substrate 10 are structurally connected to each other by the non-conductive adhesive 11 and the conductive adhesive 13.

Hereinafter, advantageous effects achieved in the present embodiment will be described.

In the high-frequency module 100, it is possible to prevent contact between the non-conductive adhesive 11 and the conductive adhesive 13 by the spacer 23, and it is possible to reduce variations of the characteristics of the antenna since the accuracy of the height between the wiring substrate 10 and the antenna substrate 20 is increased. In addition, since it is possible to achieve electric connection between the wiring substrate 10 and the antenna substrate 20 by a simple structure, it is possible to contribute to size reduction of a device.

Since the spacer 23 surrounds the non-conductive adhesive 11 and the gap 25 is formed in a portion of the spacer 23 and is not formed around the conductive adhesive 13, the conductive adhesive 13 is prevented from being mixed with the non-conductive adhesive 11, and degassing is possible in bonding the antenna substrate 20 and the wiring substrate 10 to each other. As a result, it is possible to more assuredly bond the antenna substrate 20 and the wiring substrate 10 to each other.

Since the spacer 23 is formed by the solder resist 23a on the surface of the antenna substrate 20 at the wiring substrate 10 side at which no wiring pattern is present, it is possible to increase the accuracy of the height of the spacer 23. In addition, the respective amounts of the non-conductive adhesive 11 and the conductive adhesive 13 applied in bonding the wiring substrate 10 and the antenna substrate 20 to each other are limited by the spacer 23, and thus it is possible to minimize the respective amounts of the non-conductive adhesive 11 and the conductive adhesive 13 to be used.

As described above, in the high-frequency module according to the present invention, by the spacer, it is possible to prevent contact between the non-conductive adhesive and the conductive adhesive and it is also possible to ensure a required height between the wiring substrate and the antenna substrate. In addition, since it is possible to achieve connection between the wiring substrate and the antenna substrate by a simple structure, it is possible to contribute to size reduction of a device.

The present invention is not limited to the above embodiment, and various modifications may be made without departing from the gist of the present invention, to implement the present invention.

### Reference Signs List

- 10: wiring substrate
- 11: non-conductive adhesive
- 13: conductive adhesive
- 15: electronic component
- 20: antenna substrate
- 21: antenna
- 21a: metal pattern
- 23: spacer
- 23a: solder resist
- 25: gap
- 27: electrode portion
- 27a: upper surface electrode portion
- 27b: side surface electrode portion
- 27c: lower surface electrode portion
- 28: electrode portion
- 29: through hole
- 100: high-frequency module

## Claims

1. A high-frequency module comprising:
a wiring substrate; and
an antenna substrate disposed on an upper surface of the wiring substrate, wherein
an antenna is formed by a metal pattern on the antenna substrate,
a non-conductive adhesive and a conductive adhesive are present between the wiring substrate and the antenna substrate, and
a spacer is provided between the non-conductive adhesive and the conductive adhesive.

2. The high-frequency module according to claim 1, wherein the spacer surrounds the non-conductive adhesive, and a gap is formed in a portion of the spacer and provided at a position at which the conductive adhesive is not in contact with the spacer.

3. The high-frequency module according to claim 1 or 2, wherein
the spacer is provided by a solder resist being formed on a surface of the antenna substrate at the wiring substrate side by a print method, and
the high-frequency module is produced by the non-conductive adhesive and the conductive adhesive being applied to a surface of the wiring substrate at the antenna substrate side and then the antenna substrate and the wiring substrate being bonded to each other.
